# EUROPEAN PATENT APPLICATION

(11) **EP 1 394 136 A1**
(43) Date of publication of application: **03.03.2004**
(21) Application number: 02717140.4
(22) Date of filing: 12.04.2002
(51) Int. Cl.: C04B 37/00, H01L 21/68, H05B 3/74, H05B 3/10

(54) **CERAMIC BONDED BODY AND ITS PRODUCING METHOD, AND CERAMIC STRUCTURE FOR SEMICONDUCTOR WAFER**

(30) Priority: 12.04.2001 JP 2001151731
(71) Applicant: IBIDEN CO., LTD., Ogaki-shi Gifu-ken 503-0917 (JP)
(72) Inventor: ITO, Yasutaka, Ibi-gun, Gifu 501-0601 (JP); SUGIMOTO, Keizo, Ibi-gun, Gifu 501-0601 (JP); OZAKI, Jun, Ibi-gun, Gifu 501-0601 (JP); SUGINO, Junichi, Ibi-gun, Gifu 501-0601 (JP)
(74) Representative: Schuster, Thomas, Dipl.-Phys.
(86) International application number: PCT/JP2002/003697
(87) International publication number: WO 2002/083597

(57) **Abstract**

The invention relates to a ceramic joint body and a method of producing the same and a ceramic structural body for a semiconductor wafer, and is particularly used in a semiconductor producing apparatus or an inspection apparatus such as a hot plate (ceramic heater), an electrostatic chuck, a wafer prober or the like, and basically relates to a joint body obtained by joining two or more same or different ceramic bodies, characterized in that ceramic particles grown are existent in joint interfaces of the ceramic bodies so as to infiltrate into the ceramic bodies located at both sides around the interface and the layer of a concentrated sintering aid is eliminated from the joint interface.

## Description

### TECHNICAL FIELD

This invention relates to a ceramic joint body and a method of producing the same and a ceramic structural body for a semiconductor wafer, and particularly proposes a joint structure mainly composed of a ceramic substrate and a ceramic body for the protection of the substrate and used in a semiconductor producing apparatus or an inspection apparatus such as a hot plate (ceramic heater), an electrostatic chuck, a wafer prober or the like.

### BACKGROUND ART

In general, a heater using a metallic substrate of stainless steel, an aluminum alloy or the like, a prober or the like is used in the semiconductor producing apparatus including an etching device, a chemical vapor growth apparatus or the like, or a semiconductor inspection apparatus. However, the heater made of the metallic substrate is poor in the temperature controllability and has problems that it is thick in the thickness and heavy in the weight and is bulky and further bad in the corrosion resistance to corrosive gases.

Heretofore, in order to solve these problems, there has been developed a heater using a ceramic substrate such as aluminum nitride or the like instead of the metallic substrate. As an example of such a ceramic heater, there are proposals such as US Patent No. 5231690 and the like.

Moreover, such a ceramic heater is constructed with a ceramic substrate heating a semiconductor wafer and a ceramic body for the protection of an electric conductor supplying a current to a resistor heating body inside the ceramic substrate. For this end, a technique of joining the ceramic substrate to the ceramic body is required in this type of the ceramic heater. For example, Japanese patent No. 2783980 or the like discloses a technique of joining the ceramic substrate to the ceramic body for the protection.

In the ceramic heater disclosed in US Patent No. 5231690, however, a ceramic body 30 for protecting an electric conductor 40 for power supply is arranged in a wafer treating (heating treatment) zone, so that heat of a ceramic substrate 1 is deprived by the ceramic 30 and there is a problem that a temperature of the ceramic substrate to a wafer heating face is apt to become non-uniform.

Further, in the technique disclosed in Japanese Patent No. 2783980, a layer having a higher concentration of a sintering aid is existent in a joint interface, which unexpectedly causes the deterioration of the joint strength. Moreover, it is explained in this patent that the high joint strength is obtained owing to the presence of the layer having a rich sintering aid in the joint interface. However, the inventors have an opinion different from this explanation and describe its content concretely below.

It is an object of the invention to propose a ceramic joint body having a high joint strength and no deterioration of properties in a joint portion in the joining of same or different ceramic bodies and a method of producing the same.

It is another object of the invention to propose a ceramic structural body for a semiconductor wafer capable of giving a practical and uniform temperature distribution to a face of the wafer to be treated and well joining to a ceramic body protecting an electric conductor for power supply.

### DISCLOSURE OF THE INVENTION

The inventors have made various studies in order to achieve the above objects and developed a ceramic joint body and a method of producing the same and a ceramic structural body for a semiconductor wafer as described in the following constructions 1-15. That is, the invention is as follows.
1. A ceramic joint body obtained by joining two or more same or different ceramic bodies, characterized in that ceramic particles grown are existed in joint interfaces of the ceramic bodies so as to infiltrate into the ceramic bodies located at both sides around the interface and a sintering aid is eliminated from the joint interface.
2. A ceramic joint body obtained by joining two or more same or different ceramic bodies, characterized in that ceramic particles grown are existed in joint interfaces of the ceramic bodies so as to infiltrate into the ceramic bodies located at both sides around the interface and a layer of sintering aid is eliminated from the joint interface, and the sintering aid included in the ceramic body within a region ranging from the joint interface to 3 mm is rendered into a ratio Ch/Cl of highest concentration Ch to a lowest concentration Cl is within a range of 1-100.
3. A ceramic joint body obtained by joining two or more same or different ceramic bodies, characterized in that ceramic particles grown are existed in joint interfaces of the ceramic bodies so as to infiltrate into the ceramic bodies located at both sides around the interface and a sintering aid is eliminated from the joint interface, and a concentration of the sintering aid in the ceramic body located one side around the joint interface is higher than a concentration of the sintering aid in the joint interface and a concentration of the sintering aid in the ceramic body located the other side around the joint interface is lower than the concentration of the sintering aid in the joint interface.
4. A ceramic joint body according to any one of the items 1-3, wherein at least one of the ceramic bodies contains the sintering aid and/or 50-5000 ppm of carbon.
5. A method of producing a ceramic joint body by joining two or more same or different ceramic bodies, which comprises applying a solution of a sintering aid having a concentration of 0.3 mol/l to 1 mol/l to a joint interface and firing at a temperature above 1840°C.
6. A method of producing a ceramic joint body by joining two or more same or different ceramic bodies, which comprises including a ceramic body into one-side ceramic body to be joined and including no ceramic body or making relatively small as compared with a content of the sintering aid in the one-side ceramic body and then contacting and firing these ceramic bodies with each other.
7. A method of producing a ceramic joint body according to the item 6, wherein the content of the sintering aid is 0.5-20% in a substrate and 0-10% in the ceramic body.
8. A ceramic structural body for a semiconductor wafer comprising a ceramic substrate having an electric conductor in its inside and a ceramic body having an electric conductor for power source electrically connecting to the electric conductor in the substrate and butt-joined to the ceramic substrate, characterized in that the ceramic body is joined to a portion of the ceramic substrate other than a region thereof treating a semiconductor wafer.
9. A ceramic structural body for a semiconductor wafer according to the item 8, wherein the region treating the semiconductor wafer is a face of the ceramic substrate opposing to the semiconductor wafer.
10. A ceramic structural body for a semiconductor wafer according to the item 8 or 9, wherein the ceramic substrate and the ceramic body are comprised of at least one of a nitride ceramic, an oxide ceramic and a carbide ceramic.
11. A ceramic structural body for a semiconductor wafer according to any one of the items 8 to 10, wherein it is used within a temperature region of 100-700°C.
12. A ceramic structural body for a semiconductor wafer comprising a ceramic substrate having an electric conductor in its inside and a ceramic body having an electric conductor for power source electrically connecting to the electric conductor in the substrate and butt-joined to the ceramic substrate, characterized in that ceramic particles grown are existed in joint interfaces of the ceramic bodies so as to infiltrate into the ceramic bodies located at both sides around the interface and a layer of sintering aid is eliminated from the joint interface.
13. A ceramic structural body according to the item 12, wherein the sintering aid included in the ceramic body within a region ranging from the joint interface to 3 mm is rendered into a ratio Ch/Cl of highest concentration Ch to a lowest concentration Cl is within a range of 1-100.
14. A ceramic structural body for a semiconductor wafer according to the item 12 or 13, wherein a concentration of the sintering aid in the ceramic body located one side around the joint interface is higher than a concentration of the sintering aid in the joint interface and a concentration of the sintering aid in the ceramic body located the other side around the joint interface is lower than the concentration of the sintering aid in the joint interface.
15. A ceramic structural body for a semiconductor wafer according to the item 14, wherein the content of the sintering aid in the ceramic substrate is 0.5-20% and the content of the sintering aid in the ceramic body for the protection other than the neighborhood of the joint interface is 0-10%.

### BRIEF DESCRIPTION OF THE DRAWINGS

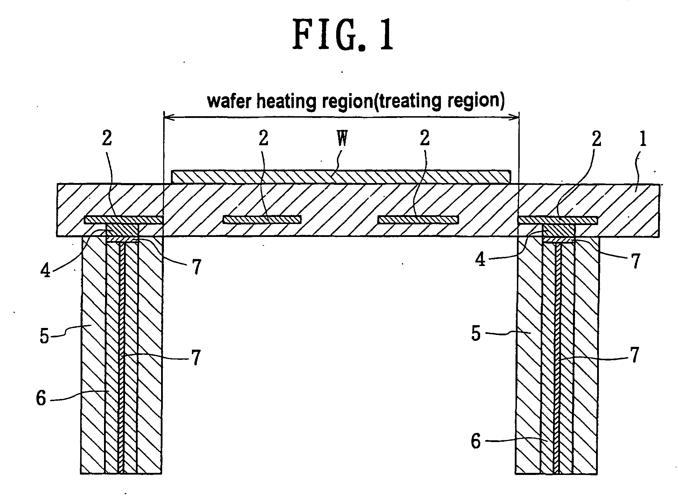

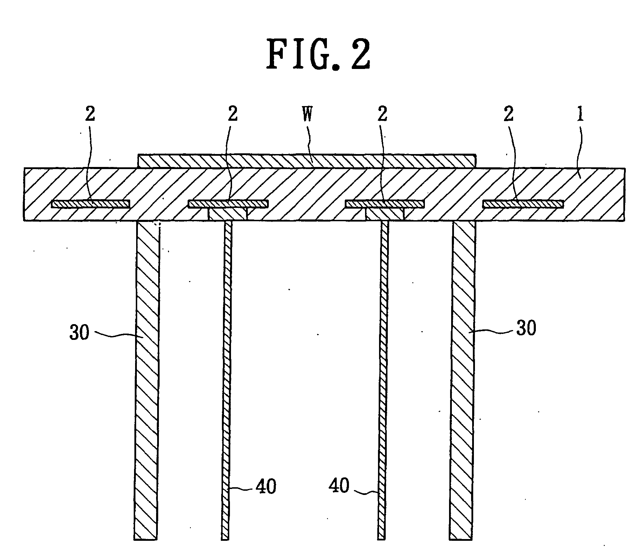

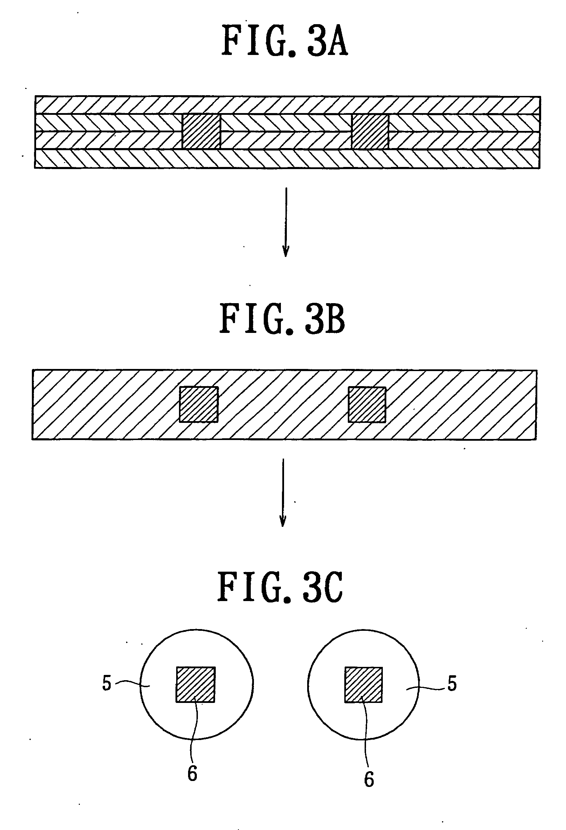

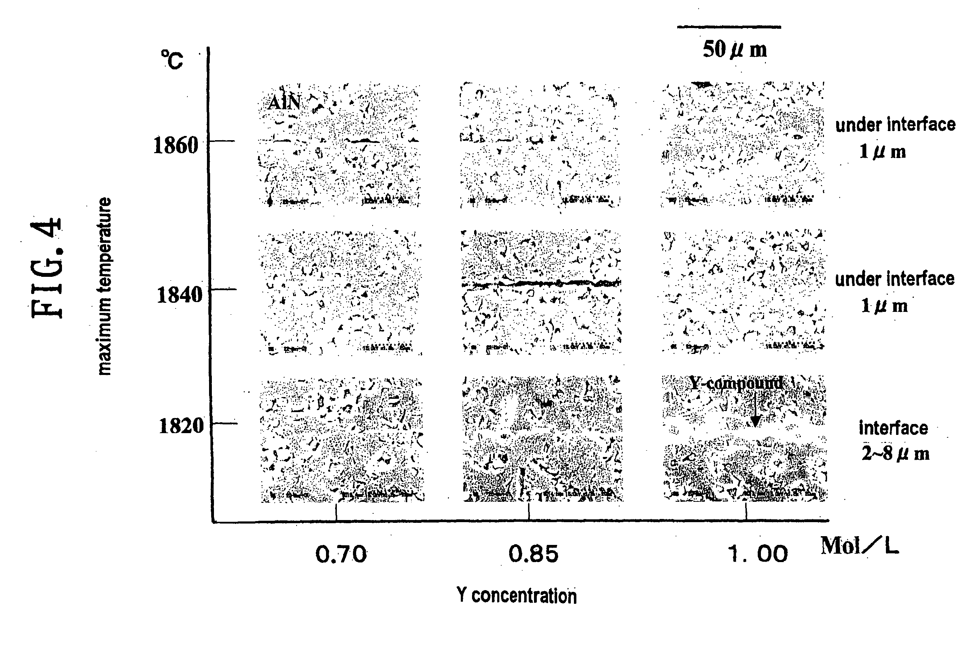

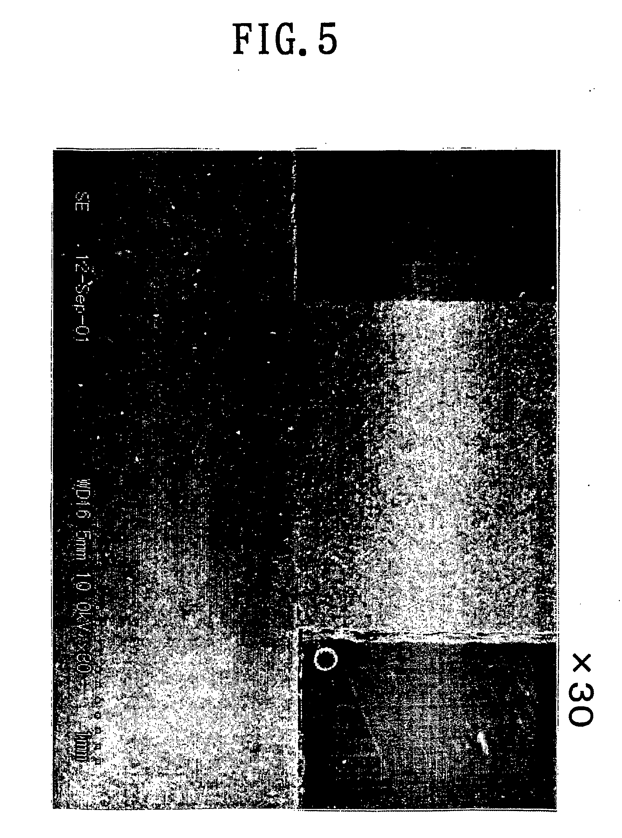

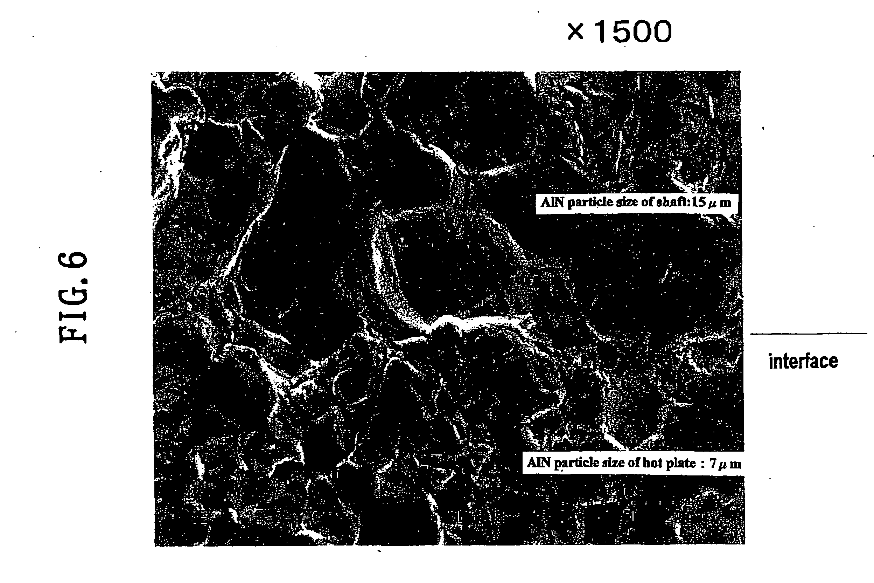

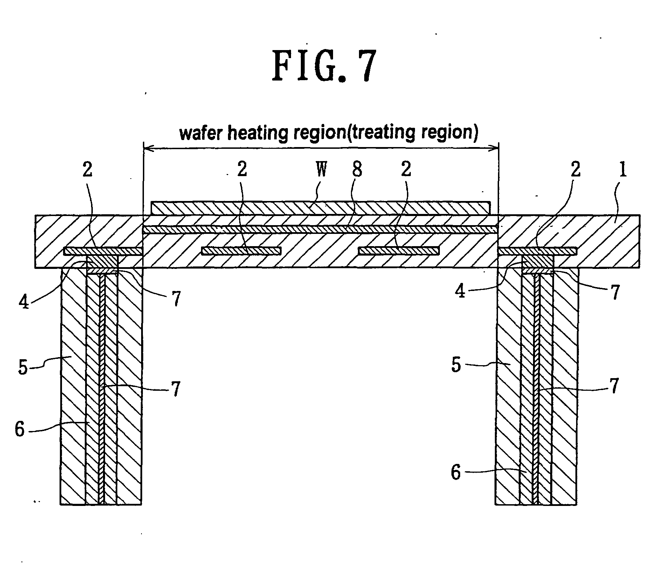

FIG. 1 is a longitudinal section view illustrating an example of the ceramic joint body for semiconductor-production and inspection apparatus according to the invention, FIG. 2 is a longitudinal section view illustrating the conventional ceramic joint body, FIG. 3 is flow sheet for producing a ceramic body for protecting an electric conductor for power supply, FIG. 4 is an electron microphotograph of a joint interface, FIG. 5 is an electron microphotograph of a joint interface (x 30 magnification), FIG. 6 is an electron microphotograph of a joint interface (x 1500 magnification), and FIG. 7 is a longitudinal section view illustrating a ceramic structural body having RF electrode.

### BEST MODE FOR CARRYING OUT THE INVENTION

The invention lies in a ceramic joint body obtained by joining two or more same or different ceramic bodies in which ceramic particles grown are existed in joint interfaces of the ceramic bodies so as to infiltrate into the ceramic bodies located at both sides around the interface and a sintering aid is eliminated from the joint interface.

In such a ceramic joint body, ceramic grown particles dispersed from each other on joint interfaces are existent in the state of getting over the joint interfaces, and as a result, the ceramic bodies can firmly join without interposing cement.

Therefore, in case of the thus jointed ceramic joint body, a layer of a sintering aid, that is, a layer (layer of a rich sintering aid, layer of a concentrated sintering aid) of the sintering aid having high concentration is nonexistent. Actually, according to the inventors' tests, as described later on, there is found no concentrated (localized) sintering aid even with an electron microscope, and even when an amount of the sintering aid around the interface is examined by a fluorescent X-ray measuring method, there is found no significant difference between the joint interface and the inside of the ceramic body.

That is, a concentrated or localized sintering aid, which is considered to be existent in the ceramic body for essentially joining, is not found.

Further, according to the inventors' study, different from an explanation of prior art, when a sintering aid is concentrated and localized on a joint interface, this portion becomes remarkably fragile, and even if particles are mixed and joined together, destruction tends to start from the sintering aid.

Another embodiment of the invention is a ceramic joint body obtained by joining two or more same or different ceramic bodies, characterized in that ceramic particles grown are existed in joint interfaces of the ceramic bodies so as to infiltrate into the ceramic bodies located at both sides around the interface and the concentrated layer of a sintering aid having high concentration is eliminated from the joint interface, and the sintering aid included in the ceramic body within a region ranging from the joint interface to 3 mm renders into a ratio Ch/Cl of the highest concentration Ch to the lowest concentration Cl within a range of 1-100.

Further, in this case, concentration Cm of a sintering aid of the joint interface is preferably between Ch and Cl. If Ch and Cl are substantially the same value, the concentration Cm of the sintering aid in the joint interface becomes substantially the same. And, Ch and Cl are preferably existent in the ceramic body on the opposite side across the joint interface.

The ratio Ch/Cl of the highest concentration Ch to the lowest concentration Cl of the sintering aid included in the ceramic body should be 1-100, preferably 1.1-25, but there is no ratio of less than 1 by definition, while the ratio of not less than 100 generates strain around the joint interface. Because the ceramic body is shrunk by the sintering aid, if concentration difference is large, strain or warp generates in joint interfaces in temperature rising. Further, if strain generates, a ceramic substrate inclines and wafer or the like cannot uniformly be heated.

Further, in case of measuring the sintering aid concentration of the ceramic body, there is used a fluorescent X-ray analyzer or energy disperse-type characteristic X-ray spectrometer (EDS). A concentration is measured from the ratio of peak intensity of the element for constituting a matrix to that of the sintering aid. For example, in case of existing Y2O3 (sintering aid) in an ALN matrix (ceramic substrate), calculation is made from the peak intensity of aluminum and that of yttrium. That is, calculation is (I(Y)/2×(I(ALN)+I(Y)))×100%.

Further, such concentration measurement is conducted at the position within a range of 3 mm at one ceramic side from the joint interface, or 3 mm at the other ceramic side therefrom.

A further embodiment of the invention is a ceramic joint body obtained by joining two or more same or different ceramic bodies, characterized in that ceramic particles grown are existed in joint interfaces of the ceramic bodies so as to infiltrate into the ceramic bodies located at both sides around the interface and the concentrated layer of a sintering aid having high concentration is eliminated from the joint interface, and a concentration of the sintering aid in the ceramic body located one side around the joint interface is higher than a concentration of the sintering aid in the joint interface and that of the sintering aid in the ceramic body located on the other side around the joint interface is lower than that of the sintering aid in the joint interface.

Such ceramic joint body is constructed to have a concentration gradient by crossing the sintering aid across the joint interface of the ceramic body, so as to have no concentrated layer of the rich sintering aid in the joint interface. That is, the particles formed toward each ceramic body are grown, respectively, and infiltrated into the other ceramic bodies to pull each other. Such joining form can contain no sintering aid in one ceramic body and contain a sintering aid in the other ceramic body, or join both by relatively minimizing the content of a sintering aid and firing them.

That is, ceramic sintered particles are grown in joint interfaces by dispersing a sintering aid from much amount to less amount so as to firmly join ceramic bodies with each other. The thus obtained ceramic joint body is not only simply produced because no aqueous solution of a sintering aid is used but also has large cementing strength. Because no sintering aid is existent, or sintering of ceramics does not progress on the side having less sintering aid so as to largely grow ceramic particles by dispersing the sintering aid.

Fig. 5 is an electron microphotograph (×1500) of a joint structure having such concentration gradient, where it is understood that a particle size is larger at the side (shaft side) of less sintering aid than the side (hot plate side) thereof so as to make particle growth much more progress.

The content of the sintering aid on the side of a relatively high concentration is desirably 0.5-20%. The reason is that the amount of less than 0.5% lowers cementing strength. Further, as the sintering aid, a yttrium compound or ytterbium compound is desirable. These sintering aids are desirably contained within at least one ceramic body beforehand. The reason is that ceramic particles grow quickly in joint interfaces so as to bring about action of erasing the concentrated layer of the sintering aid in the joint interface.

Further, the sintering aid in the invention means substance having the accelerating action of sintering ceramics, and is synonymous with the joining aid. Joint utilizes the principle of a sintering reaction. As the sintering aid, use may preferably be made of yttrium halide and ytterbium halide among the yttrium compound or ytterbium compound. It is assumed that these have reduction strength for removing an oxide film on the joint interface and helping dispersion of the joining aid. Further, those are aqueous for preparing a coating solution easily.

Next, there is explained a method of joining the ceramic bodies each other.

The first method is, in case of joining two or more same or different ceramic bodies, to apply a solution of a sintering aid having a concentration of 0.3 mol/l to 1 mol/l to a joint interface and to fire at a temperature above 1840°C . In this method, the reason why the concentration is less than 0.3 mol/l is that, as described in Japanese Patent No. 2783980, on the joint interface is formed a concentrated layer (marked with a white continuous line) of a sintering aid having a high concentration, and strength becomes insufficient. Its cause is not known, but it is assumed that a poor concentration makes reduction weak and an oxide film of the joint interface cannot be removed. Further, a concentration of not less than 1 mol/l can not disperse a sintering aid, and a layer of the concentrated sintering aid having a high concentration appears. Further, a firing temperature of less than 1840°C, diffusion of a sintering aid does not proceed, and a layer of the concentrated sintering aid appears. The firing time is desirably 30 minutes to 3 hours.

That is, this concentration range is a unique range having no layer (marked with a white continuous line) of a concentrated sintering aid having a high concentration and high strength. This is judged from Fig. 4. Fig. 4 is a photograph of a joint interface, which abscissa shows the cases of applying a solution having concentrations of 0.7 mol/l, 0.85 mol/l and 1.00 mol/l from the left, and ordinate shows the cases of treating at firing temperatures of 1860°C, 1840°C and 1820°C from the above.

As understood from these photographs, under the firing condition of using aqueous solutions of 0.7 mol/l and 0.85 mol/l at 1860°C, there is existent no yttria layer on the joint interface. But, in case of applying an aqueous solution of 1 mol/l, a white line can be confirmed on the joint interface at any temperature and a yttria layer is existent. Further, even with the use of aqueous solutions of 0.7 mol/l and 0.85 mol/l, if the firing condition is less than 1840°C, a white line is confirmed, and a yttria layer is existent.

As a method of producing another ceramic joint body, in case of joining two or more same or different ceramic bodies, a sintering aid is contained in a one-side ceramic body to be joined and a sintering aid is not or relatively less contained in the other side than the content of the sintering aid of the one-side ceramic body, and these ceramic bodies are made into contact with each other and firing them.

According to such producing method, diffusion starts from much sintering aid to less sintering aid, particles enter into the side of less sintering aid to break a boundary, while sintering does not proceed in ceramics on the side of less sintering aid, so that ceramic particles can largely be grown at a joint interface together with diffusion of the sintering aid (see Fig. 5).

In this example, the content of a sintering aid in the ceramic body on the side of much sintering aid is desirably not less than 0.5%. Because the content of less than 0.5 wt% of a sintering aid lowers joint strength.

The face roughness of a joint interface is preferably less than 100µm of Rmax. If it exceeds 100µm of Rmax, joint strength lowers. Further, even if Ra is made smaller as possible, if Rmax exceeds 100µm, joint strength lowers. Control of Rmax is more necessary than Ra. The joint strength is, when using aluminium nitride, 700 MPa by a four-point bending test. On the other hand, when a layer (rich layer) of a concentrated sintering aid having a high concentration is existent, the joint strength is found to be low as 400 MPa.

Next, a practical example of the invention with the use of the aforesaid ceramic joint body is explained.

This example relates to a ceramic structural body for a semiconductor wafer comprising a ceramic substrate having an electric conductor in its inside and a ceramic body having an electric conductor for power supply electrically connecting to the electric conductor in the substrate, characterized in that the ceramic body is joined to a portion of the ceramic substrate other than a region thereof treating a semiconductor water.

In such a ceramic structural body, as described above, the ceramic body and the ceramic substrate are particle dispersion joined by mutually growing particles for forming the ceramic body toward both sides of the joint interface. Moreover, in such a structure, no layer of the concentrated sintering aid having a high concentration is substantially existent in the joint interface. This is clear from an electron microscope observation, and it is further clear from the fact that there is found no significant difference between the joint interface and the inside of the ceramic body even when an amount of the sintering aid in the vicinity of the interface is examined by a fluorescent X-ray measuring method. That is, the sintering aid is existent on the side of the ceramic body faced on the joint interface, but the sintering aid is not concentrated in the joint interface itself. That is, there is formed no concentrated portion (rich layer) of the sintering aid (cementing aid). According to the inventors' knowledge, it is found that such layer of the sintering aid is fragile, and even if particles are specially grown and cemented for intermixing, breakdown tends to occur from the layer of the sintering aid as the starting point. In this point, the layer of the concentrated sintering aid is excluded from the joint interface, while the ceramic body and the the ceramic substrate are completely integrated by interpositing with grown particles across the interface as in the invention. Such joint structure also secures air tightness and prevents from corrosion of the electric conductor for power supply in the inside of the ceramic body with an atmospheric gas. The invention accomplishes a helium leak amount of less than 1×10-11 (Pa·m3/sec).

As explained above, in the ceramic structural body according to the invention, a layer of the concentrated sintering aid is not existent in the joint interface between the ceramic substrate and the ceramic body, and in a range up to 3 mm of both sides around the joint interface, the ratio between the highest concentration Ch and the lowest concentration Cl of the sintering aid is Ch/Cl=1-100.

Further, in this case, the concentration Cm of the sintering aid of the joint interface is preferably a value between Ch and Cl. If Ch and Cl are substantially the same, the concentration Cm of the sintering aid in the joint interface substantially agrees to these values. Further, Ch and Cl are preferably existent in the ceramic bodies on the opposite sides faced each other across the joint interface.

The ratio Ch/Cl of the highest concentration and the lowest concentration included in the ceramic body is 1-100, preferably 1.1-25, but less than 1 of this ratio is not substantial, while when it exceeds 100, strain generates in the vicinity of the joint interface. Because the sintering aid has a property of shrinking the ceramic body, if a concentration difference is large, strain or warp generates in the joint interface in case of temperature rising. When the strain generates, the ceramic substrate is inclined, and a wafer or the like becomes difficult to be uniformly heated.

In the ceramic joint body, it is desirable that no layer of the concentrated sintering aid is existent between the ceramic substrate and the ceramic body, and the concentration of the sintering aid in the ceramic body on one side around the joint interface is higher than that of the sintering aid of the joint interface and lower than that of the sintering aid in the ceramic body on the opposite side around the joint interface.

Such ceramic structural body is constructed to have a concentration gradient across the joint interface of the ceramic body by the sintering aid, and although any layer of the rich sintering aid is not existent in the, joint interface, particles for forming the ceramic body are grown toward each ceramic body side, mutually e infiltrated into the other ceramic body and joined each other. Such joining form can be obtained by containing the sintering aid in one ceramic body and not containing or relatively less containing the sintering aid in the other ceramic body so as to join both and fire.

That is, by dispersing the sintering aid from a much amount to a less amount, ceramic sintered particles are grown on the joint interface and ceramic bodies are firmly joined together. Without the use of any aqueous solution of the sintering aid, such joint body is simply produced and joint strength becomes high.

It is desirable that the content of the sintering aid in the ceramic substrate is 0.5%-20%, and the content of the sintering aid in the ceramic body is 0-10%, except the vicinity of the joint interface. If the content of the sintering aid is less than 0.5 wt%, joint strength lowers. And, if the concentration of the sintering aid is less than 0.5 wt%, the sintering does not proceed, and warp generates with dead load by temperature rising because of existing pores, while if it exceeds 20%, the sintering proceeds because of much sintering aid, and the ceramic substrate is warped with dead load. In either case, uniform heating cannot be carried out. Further, if the existing amount of the sintering aid in the ceramic body exceeds 10%, thermal conductivity becomes high, and if the ceramic substrate is tried to be functioned as a heater, heat passes to flow out and heated face temperature uniformity is lowered.

For measurement of the concentration is used a fluorescent X-ray analyzer or energy dispersion-type characteristic X-ray spectroscope (EDS). The concentration is formed from a ratio of peak intensity of the element for constructing a matrix to peak intensity of the sintering aid. For example, in case of existing Y2O3 in an ALN matrix, the concentration is calculated from peak intensity of aluminium and that of yttrium. That is, calculation is made by (I(Y)/2×(I(ALN)+I(Y)))×100%.

Next, a still further structural body of the invention is explained.

This example is a ceramic structural body for a semiconductor wafer comprising a ceramic substrate having an electric conductor (resistance heat generator) in its inside and a ceramic body having an electric conductor for power supply electrically connecting to the electric conductor in the substrate and joined to the ceramic substrate, characterized in that the ceramic body is joined to the ceramic substrate other than a treating region of the semiconductor wafer.

According to such structure, the ceramic structural body is joined to the ceramic substrate other than a treating region of a semiconductor wafer, so that even in case of particularly heating the wafer at a high temperature such as 100-700°C, heat is not taken out of the ceramic body having protective function, and a temperature of a wafer heating face can be uniformalized in its return. Moreover, as the ceramic body protects the electric conductor for power supply, it is possible to use in corrosive gas without inviting corrosion.

The ceramic structural body explained above can be used in various portions of semiconductor producing inspecting device such as CVD device, sputtering device or the like. In the invention, the electric conductor within the ceramic substrate can be applied to any of heat generator, guard electrode, grand electrode, plasma electrode and RF electrode. Further, the electric conductor may be plural. The treating region of the semiconductor wafer of the ceramic substrate is a surface opposed to the semiconductor wafer. In case of using as a heater, the treating region of the semiconductor wafer becomes a wafer heating region.

Next, an embodiment of the ceramic structural body according to the invention is explained on the basis of Fig. 1. Fig. 1 is an example of embedding an electric conductor 2 functioning as a resistant heat generator in the inside of a ceramic substrate 1. In this example, a ceramic body 5 is butt-joined to a ceramic substrate 1 for protecting an electric conductor 6 for power supply from corrosive gas. Its joining method basically utilizes a sintering aid as described above. Further, the electric conductor 6 is formed with an aperture at the central portion by electrical discharge machining, so as to join a through-hole (pad) 4 to the electric conductor 6 by injecting a brazing filler 7. Since the ceramic body 5 having protective function is outside of the wafer heating region in such structure, heat is not taken by the ceramic body, and uniformity of temperature on the whole plate surface can easily be obtained.

As a method of producing the ceramic body 5 having protective function, as shown in Fig. 3, a partly broken green sheet and a not broken green sheet are laminated, the broken portion is filled by printing conductive paste (A), then, sintered (B), and processed (C) to a columnar shape by cutting.

Thickness of the ceramic substrate 1 is preferably less than 25 mm. If the thickness of the ceramic substrate 1 exceeds 25 mm, heat capacity of the ceramic substrate becomes large, particularly, when heating and cooling by providing a temperature control means, temperature followup ability is lowered due to the size of heat capacity. Further, thickness of the ceramic substrate 1 is less than 10 mm, particularly desirably less than 5 mm. If the thickness exceeds 10 mm, heat capacity above 200°C becomes large, temperature controllability and temperature uniformity on the face for plating the semiconductor wafer are liable to lower.

The ceramic substrate 1 can be used in the temperature region at 100-700°C. Particularly, in the region above 100°C, Young's modulus of ceramics lowers to generate warp, so that it is useful to use the substrate according to the invention.

The ceramic substrate 1 is desirably provided with a plurality of through-holes for inserting lifter pins of a semiconductor wafer W. A diameter of the through-hole is 0.5 mm-30 mm. Further, in the ceramic substrate, besides placing the semiconductor wafer W on one face of the ceramic substrate 1 as a contact condition, there is such a case that a protruded portion of the ceramic surface and the semiconductor wafer are supported with a supporting pin (or lifter pin) or the like so as to hold by keeping a certain space from the ceramic substrate 1. The placing and holding face of the semiconductor wafer is expressed as a wafer treating face hereinafter. Further, in case of heating by keeping a certain distance between the ceramic substrate and the semiconductor wafer, its clearance is desirably 50 µm to 5000 µm.

In case of heating by keeping a distance between the ceramic substrate and the semiconductor wafer constant, if the distance between the wafer and a holding area of the ceramic substrate cannot be kept constant, the wafer cannot uniformly be heated. Therefore, it is necessary to minimize a warp amount of the ceramic substrate, and the invention advantageously acts thereon. In the invention, the warp amount of less than 70 µm is desirable in case of using within a temperature range of 100°C -700°C. When exceeding 70 µm, the distance between a treating face (heating face) of the ceramic substrate and the wafer becomes uneven, and the wafer cannot be heated uniformly.

The reason why a diameter of the ceramic substrate is limited to that exceeding 250 mm is because the diameter of not less than 10 inch of the semiconductor wafer becomes main, and the ceramic substrate is sought to be enlarged. The ceramic substrate is desirably not less than 12 inch (300 mm). It becomes the mainstream of semiconductor wafer in the next generation. Also, if a diameter of the ceramic substrate exceeds 250 mm, warp tends to generate by dead load or the like at high temperature. Such warp is noticeable in ceramics of less than 25 mm in thickness. The invention can prevent warp by controlling a sintering aid concentration in the ceramic substrate where warp tends to generate at high temperature.

The electric conductor is desirably provided in a region at a position of 70%, particularly 60% in the thickness direction from an opposite side face of the treating face of the wafer of the ceramic substrate or a face on the opposite side. The warp generates by dead load, or, pressure of a probe, in case of a wafer prober. As the electric conductor, mention is made of conductive ceramic, metallic foil, metal sintered body, metal wire and the like. Further, when functioning as a resistance heat generator, the electric conductor is formed to a position of 80% in the thickness direction from an opposite side face of the wafer treating face of the ceramic substrate, and particularly desirably formed in a region to a position of 50% or in the opposite side face. It means that heat is transmitted from the heat generator to the wafer treating face through the inside of the ceramic substrate for dispersing and soaking in the ceramic substrate, and a large distance between the wafer treating face and the heat generator is easy to uniformize a surface temperature of the wafer treating face.

A porosity and a pore size of the maximum pore are controlled by pressure hour at the time of sintering, pressure, temperature and additive such as SiC, BN or the like. SiC and BN prevent sintering so as to introduce pore.

Ceramic material for forming a ceramic substrate of the invention is not particularly limited, but mention may be made of nitride ceramic, carbide ceramic, oxide ceramic or the like, for example. As an example of the nitride ceramic, mention may be made of metal nitride ceramic, such as aluminium nitride, silicon nitride, boron nitride, titanium nitride or the like.

Further, as an example of the carbide ceramic, mention may be made of metal carbide ceramic, such as silicon carbide, zirconium carbide, titanium carbide, tantalum carbide, tungsten carbide or the like. Further, as an example of the oxide ceramic, mention may be made of metal oxide ceramic, such as alumina, zirconia, cordierite, mullite or the like.

These ceramics may be used as a single one or more than two. Among these ceramics, nitride ceramic and oxide ceramic are preferable. They hardly generate warp at high temperature. Further, among nitride ceramics, nitride aluminium is most preferable. Because its thermal conductivity is highest as 180 W/m·K.

In the invention, as described before, it is desirable to contain a sintering aid (cementing aid) in the ceramic substrate. As sintering aids, use can be made of alkali metal oxide, alkali metal chloride, alkali metal nitrate, alkali earth metal oxide, alkali earth metal chloride, alkali earth nitrate, rare earth oxide, rare earth chloride and rare earth nitrate. Among these sintering aids, CaO, Y₂O₃, yttrium chloride, ytterbium chloride, Na₂O₃, Li₂O and Rb₂O₃ are preferable. Further, alumina may be used. As their content, 0.1-20 wt% is desirable. As being water-soluble, the chloride is advantageous for coating, and as being reducible, it is assumed to be easily dispersed in ceramic as removing the oxide film of a joint interface.

The invention desirably contains carbon of 50-5000 ppm in each ceramic body. Because the existence of carbon can form heat resistance on a joint interface without lowering joint strength. This is considered that carbon is taken in the amorphous condition with the sintering aid in case of growing ceramic particles in the joint interface or the crystallinity of a ceramic particle is lowered by solving in particles. Carbon is usually used for improving thermal conductivity, but the invention rather uses it as heat resistance. Therefore, heat resistance from a ceramic body to the other ceramic body can be prevented without inviting any lowering of joint strength. If a carbon amount is little, the function of heat resistance cannot be confirmed, and if the carbon amount is much, carbon's inherent function of joining ceramics cannot be performed. The most advantageous carbon amount is 50-5000 ppm for joining. The formation of such heat resistance on the joint interface transmits heat from the ceramic substrate to the ceramic body so as to effectively prevent non-uniform temperature distribution on the heating face when using the ceramic substrate as a heater. Further, in case of usually sintering ceramic powder, a binder is used, but it is common to degrease, and carbon is less than 30 ppm. Carbon may be contained in either one or both of the ceramic substrate and the ceramic body (ceramic protector). The ceramic substrate can be blackened by containing carbon, and radiant heat can fully be utilized when using the ceramic substrate as a heater.

Carbon may be amorphous or crystal. The use of amorphous carbon can prevent the lowering of volume resistivity at high temperature, while the use of crystal carbon can prevent the lowering of heat conductivity at high temperature. Therefore, in compliance with uses, both the crystal and amorphous carbons may be employed. Further, a more preferable range of the carbon content is 200-2000 ppm.

In case of containing carbon in the ceramic substrate, it is desirable to contain the carbon to make its brightness less than N6 as a value based on JIS Z 8 721. That having brightness of this degree is excellent in radiant heat value and concealment.

Here, brightness N indicates marks of N0-N10 by making ideal black brightness 0 and ideal white brightness 10, and dividing each color into 10 to make perception of the color brightness an equal rate between black brightness and white one. Actual measurement of the brightness is carried out by comparing color chips corresponding to N0-N10 each other. The first decimal place in this case is made 0 or 5.

The ceramic substrate of the invention is a ceramic substrate used in a device for producing or inspecting a semiconductor, and as a concrete device, mention may be made of electrostatic chuck, wafer prober, hot plate, susceptor or the like. As a conductor (resistive heat generator) embedded in the ceramic substrate, mention may be made of metal or conductive ceramic sintered body, metal foil, metal wire or the like, for example. As a metal sintered body, at least one selected from tungsten and molybdenum is preferable. Because these metals have a resistance value comparatively hard to be oxidized and sufficient enough to generate heat.

Further, as a conductive ceramic, use may be made of at least one selected from tungsten and carbide of molybdenum. As a metal foil to be used as a resistive heat generator, it may be preferable to make a resistive heat generator by pattern-forming nickel foil or stainless foil by etching. The patterned metal foil may be stuck with a resin film or the like. As a metal wire, mention may be made of tungsten wire, molybdenum wire or the like, for example.

### [EXAMPLES]

The invention is explained in more detail below. (Example 1) AlN-made electrostatic chuck with heater (Fig. 1)
(1) With the use of a paste prepared by mixing 100 parts by weight of aluminium nitride powder (made by Tokuyama, mean grain size: 1.1 µm) fired at 500°C for 1 hour in air, 4 parts by weight of yttrium (mean grain size: 0.4 µm), 11.5 parts by weight of an acry binder, 0.5 part by weight of a dispersant and 53 parts by weight of alcohol consisting of 1-butanol and ethanol, a green sheet of 0.47 mm thick is obtained by molding by a doctor blade method.
(2) After dried at 80°C for 5 hours, the green sheet necessary for processing is provided with portions to be through-holes for inserting semiconductor wafer support pins (lifter pins) of 1.8 mm, 3.0 mm and 5.0 mm in diameter and through-holes (pads) 4 for connecting an electric conductor for power supply by punching.
(3) A conductor paste A is prepared by mixing 100 parts by weight of tungsten carbide particle having a mean grain size of 1 µm, 3.0 parts by weight of an acryl binder, 3.5 parts by weight of an α-terpineol solvent and 0.3 part by weight of a dispersant.
(4) The conductor paste A is filled in the through-hole (pad) 4 for connecting an external terminal. And, a laminate is formed by laminating 34-60 green sheets printed no paste on the upper side (heating face) of the green sheet printed a resistive heat generator pattern and formed and 13-30 green sheets on the lower side thereof and pressing them at 130°C with pressure of 80 kg/cm².
(5) The laminate is degreased in nitrogen gas at 600°C for 5 hours and hot-pressed at 1890°C with pressure of 150 kg/cm2 for 3 hours to form an aluminium nitride flat body 1.
(6) With the use of the green sheet obtained in (1) and the paste obtained in (3), there is sintered and formed a ceramic sheet buried tungsten carbide therein (Figs. 3A and 3B).
   This sheet is cut along the tungsten carbide and machined to a column (Fig. 3C). Further, a through-hole is formed in the tungsten carbide electric conductor by electric discharge machining as a ceramic body 5 having protective function.
(7) To a joint face of the ceramic body 5 is applied a yttrium chloride solution of 0.7 mol/l, dried, heated in nitrogen at 1860°C and left for 3 hours as pressing the ceramic body 5 and the ceramic substrate 1 with pressure of 1 kg/cm2. Further, a gold solder consisting of Ni-Au is poured from the through-hole and heat-reflowed at 900°C to complete connection.

### (Example 2)

To a joint face of the ceramic body 5 is applied a yttrium chloride solution of 0.85 mol/l, dried, heated in nitrogen at 1860°C and left for 3 hours as pressing the ceramic body and the ceramic substrate 1 with pressure of 1 kg/cm2.

### (Example 3)

The example is the same as Example 1, but this is an example of using silicon nitride as the ceramic substrate.

Concretely, with the use of a paste prepared by mixing 100 parts by weight of silicon nitride (mean grain size: 0.4 µm), 124 part by weight of ytterbium oxide (mean grain size: 0.4 µm), 11.5 parts by weight of an acryl binder, 0.5 parts by weight of a dispersant and 53 parts by weight of 1-butanol and ethanol, a green sheet of 0.47mm thick is obtained by molding by a doctor blade method. Further, as the sinering aid applied to the green sheet, a yttrium chloride solution of 0.3 mol/l is used.

### (Comparative Example 1)

Just the same as Example 1, but to the joint face of a ceramic body 5 is applied a yttrium chloride solution of 1 mol/l, dried, heated at 1860°C as pressing the ceramic body 5 and the ceramic substrate 1 with pressure of 1 kg/cm2 and left for 3 hours.

### (Comparative Example 2)

Just the same as Example 1, but to the joint face of a ceramic body 5 is applied a yttrium chloride solution of 0.26 ml/l, dried, heated at 1860°C as pressing the ceramic body 5 and the ceramic substrate 1 with pressure of 1 kg/cm2 and left for 3 hours.

### (Comparative Example 3)

Just the same as Example 1, but to the joint face of a ceramic body 5 is applied a yttrium chloride solution of 0.7 mol/l, dried, heated at 1840°C as pressing the ceramic body 5 and the ceramic substrate 1 with pressure of 1 kg/cm2 and left for 3 hours.

### (Example 4)

This example employs the same joining method as in Example 1, but shown in Fig. 2, the ceramic body for protecting a conductor is made tubular to provide a wafer heating region, and a copper wire is used as an electric conductor. A tubular (cylindrical) protective ceramic body is produced as follows.

With the use of a composition prepared by mixing 100 parts by weight of aluminium nitride powder (made by Tokuyama Co., mean grain size: 1.1 µm), 4 parts by weight of Y2O3 (mean grain size: 0.4 µm), 11.5 parts by weight of an acrylic resin binder, 0.5 part by weight of a dispersant and 53 parts by weight of alcohol consisting of 1-butanol and ethanol, a granule is produced by a spray-dry method, the granule is put in a substantially cylindrical die having a flange portion at the end and sintered with normal pressure at 1890°C to form a tubular (cylindrical) body of 200 mm in length, 45 mm in major diameter and 35 mm in minor diameter having a flange portion at the end.

### (Example 5)

(1) With the use of a paste prepared by mixing 100 parts by weight of aluminium nitride powder (made by Tokuyama Co., mean grain size: 1.1 µm) fired in air at 500°C for 1 hour, a predetermined amount of yttria (mean grain size: 0.4 µm), 11.5 parts by weight of an acryl binder, 0.5 part by weight of a dispersant and 53 parts by weight of alcohol consisting of 1-butanol and ethanol, a green sheet of 0.47 mm thick is obtained by molding by a doctor blade method.
(2) After dried at 80°C for 5 hours, the green sheet necessary for processing is provided with portions to be through-holes for inserting semiconductor wafer support pins (lifter pins) of 1.8 mm, 3.0 mm and 5.0 mm in diameter and through-holes (pads) 4 for connecting an electric conductor by punching.
(3) A conductor paste A is prepared by mixing 100 parts by weight of tungsten carbide particle having a mean grain size of 1 µm, 3.0 parts by weight of an acryl binder, 3.5 parts by weight of an α-terpineol solvent and 0.3 part by weight of a dispersant.
(4) The conductor paste A is filled in the through-hole (pad) 4 for connecting an external terminal. And, a laminate is formed by laminating 34-60 green sheets printed no paste on the upper side (heating face) of the green sheet printed and formed a resistive heat generator pattern and 13-30 green sheets on the lower side thereof and further laminated the green sheet printed an RF electrode pattern (grid-like)8 thereon, and furthermore laminated two green sheets printed no pattern and pressing them at 130°C with pressure of 80 kg/cm2.
(5) The laminate is degreased in nitrogen gas at 600°C for 5 hours and hot-pressed at 1890°C with pressure of 150 kg/cm2 for 3 hours to form an aluminium nitride flat body 1.
(6) With the use of a composition added no yttria thereto in the green sheet obtained in (1) and the paste of (3), there is sintered and formed a ceramic sheet buried tungsten carbide therein (Figs. 3A and 3B). The sheet is cut along the tungsten carbide and machined to a column (Fig. 3C). Further, a through-hole is formed in the tungsten carbide electric conductor by electric discharge machining as a ceramic body 5 having protective function.
(7) The ceramic body 5 and the ceramic substrate 1 are heated at a predetermined temperature as pressing with pressure of 2 kg/cm² and left for a predetermine hour. Further, gold solder 7 consisting of Ni-Au is poured from the through-hole and heat-reflowed at 900°C to complete connection (Fig. 7).

Table 1 measures concentration of yttria (sintering aid) contained in the raw material of a ceramic substrate, sintering temperature, time and concentration (Ch) of the sintering aid at the position of 3 mm on the ceramic substrate side from a joint interface for joining, concentration (Cl) of the sintering aid at the position of 3 mm on the ceramic protective body side from the joint interface, concentration (Cm) of the sintering aid in the joint interface measured by an energy dispersive characteristic X-ray spectroscope EDS (made by Hitachi, S-430 FESEM), and further carbon concentration, joining strength, helium leak amount, existence of corrosion of electrode in CF4 plasma gas, warp amount at the time of temperature up to 550°C and temperature distribution at 550°C. The carbon concentration is measured by crushing the ceramic substrate and ceramic protective body, heating them at 500-800°C and collecting CO2 gas generated therefrom. The helium leak amount is measured by a helium detector (made by Shimadzu, "MSE-11AU/TP type") with the use of a sample of 706.5 mm² in area and 1 mm in thickness.

As a result of this test, it is found that when Ch/Cl exceeds 100, the ceramic substrate is warped, temperature uniformity of the wafer is lowered and the helium amount is increased to decrease air tightness. As a result, it is found that corrosion of the electrode is generated. The value of Cm is a value between Ch and Cl.

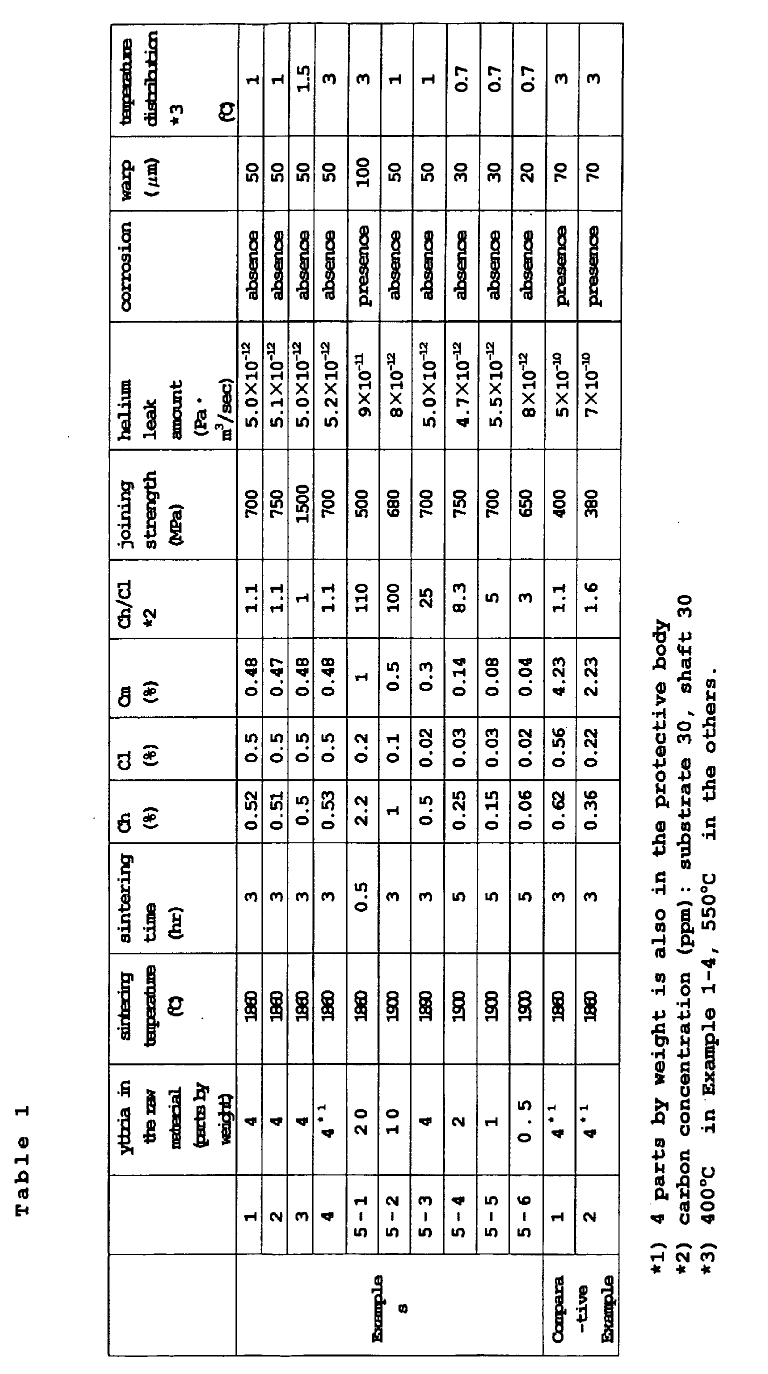

### (Example 6) Relation between carbon concentration and diffusion performance

Just the same as Example 4, but a ceramic substrate and a protective ceramic are made under the condition shown in Table 2. Further, as a tubular (cylindrical) body, the one having the following composition is used.

With the use of a composition prepared by mixing 100 parts by weight of aluminium nitride powder (made by Tokuyama Co., mean grain size 1.1 µm), 11.5 parts by weight of an acrylic resin powder, 0.5 part by weight of a dispersant and 53 parts by weight of alcohol consisting of 1-butanol and ethanol, granules are produced by a spray-dry method, and the granules are put in a substantially cylindrical die having a flange portion at the end portion and sintered at normal pressure and 1890°C to form a tubular (cylindrical) body having a flange portion of 200 mm in length, 45 mm in major diameter and 35 mm in minor diameter having a flange portion at the end portion. To this protective ceramic body is added a sintering aid.

In the degreased mold body is remained about 30 ppm of carbon, but a sample made as 50-5000 ppm by adding carbon does not lower temperature on the heating face. Why heat resistance is obtained is within the stage of presumption, but it is considered that amorphous carbon is taken in when ceramic particles are grown in the joint interface by the sintering aid or the carbon is solved in crystals to lower crystallinity of AlN.

The full mechanism is not clear, but if the sintering aid is existent in the joint interface, ceramic particles are grown for spreading on both sides of the joint interface and carbon of 50-5000 ppm is existent in the ceramic body, heat resistance is formed.

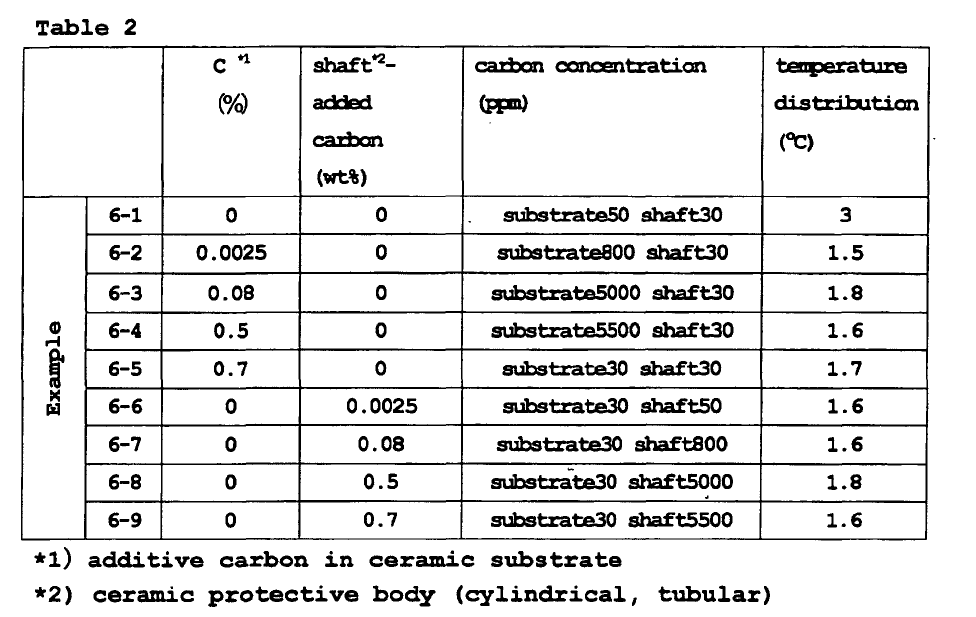

Next, with respect to heaters of the above examples and comparative examples, the following evaluation tests are carried out.

### (1) Uniformity of surface temperature

Temperatures at each position in the wafer treating face are measured by raising temperature to 400°C with the use of a thermoviwer (made by Nippon Datum, IR162012-0012), and temperature difference between the lowest temperature and the highest temperature is obtained.

### (2) Joint strength

Joint strength is measured by a four-point bending test.

According to the result of the above evaluation tests, temperature difference of the heating face is 1.0°C, 1.0°C and 1.5°C in Examples 1, 2 and 3, and 3°C in Example 4. Further, bending strength is 700 MPa, 750 MPa and 1500 MPa in Examples 1, 2 and 3, and 400 MPa, 380 MPa and 400 MPa in Comparative Examples 1, 2 and 3, respectively.

Then, in case of using silicon nitride in Japanese Patent No. 2783980, the bending strength is 900 MPa, while Example 3 of the invention is in excess thereof.

In Examples 1-3, a white line of yttria as the sintering aid is not observed in the joint interface, but observed in Comparative Examples 1-3.

As understood from Fig. 4, in case of sintering at 1880°C, even when yttrium chloride having concentration of 0.7 mol/l and 0.85 mol/l is applied, no white line of yttria is observed in the joint interface.

Yttria concentration is 0.52% within 3 mm from the joint interface to the ceramic substrate, 0.50% on the joint interface and 0.48% within 3 mm from the joint interface to the ceramic protective body measured by an energy dispersive type characteristic X-ray spectroscope EDS (Hitachi, Ltd., S-430FESEM), and the concentration is generally the same.

Yttria concentration in Comparative Example 1 is 0.62% at the position displaced 3 mm from the joint interface to the ceramic substrate, 4.23% on the joint interface and 0.56% at the position displaced 3 mm from the joint interface to the ceramic protective body measured by the energy dispersive type characteristic X-ray spectroscope. Yttria concentration in Comparative Example 2 is 0.22% at the position displaced 3 mm from the joint interface to the ceramic substrate, 2.23% on the joint interface and 0.36% at the position displaced 3 mm from the joint interface to the ceramic protective body measured by the energy dispersive type characteristic X-ray spectroscope. It is assumed that an oxide film on the ceramic face cannot be removed and diffusion does not proceed because of a small amount of the sintering aid.

### INDUSTRIAL AVAILABITY

The invention is used as each component of a semiconductor producing apparatus and a semiconductor inspection apparatus such as a CVD apparatus and a sputtering device having a hot plate (ceramic heater), an electrostatic chuck, a wafer prober susceptor or the like.

## Claims

1. A ceramic joint body obtained by joining two or more same or different ceramic bodies, **characterized in that** ceramic particles grown are existed in joint interfaces of the ceramic bodies so as to infiltrate into the ceramic bodies located at both sides around the interface and a layer of sintering aid is eliminated from the joint interface.

2. A ceramic joint body obtained by joining two or more same or different ceramic bodies, **characterized in that** ceramic particles grown are existed in joint interfaces of the ceramic bodies so as to infiltrate into the ceramic bodies located at both sides around the interface and a layer of sintering aid is eliminated from the joint interface, and the sintering aid included in the ceramic body within a region ranging from the joint interface to 3 mm is rendered into a ratio Ch/Cl of the highest concentration Ch to the lowest concentration Cl within a range of 1-100.

3. A ceramic joint body obtained by joining two or more same or different ceramic bodies, **characterized in that** ceramic particles grown are existed in joint interfaces of the ceramic bodies so as to infiltrate into the ceramic bodies located at both sides around the interface and a layer of sintering aid is eliminated from the joint interface, and a concentration of the sintering aid in the ceramic body located one side around the joint interface is higher than a concentration of the sintering aid in the joint interface and a concentration of the sintering aid in the ceramic body located the other side around the joint interface is lower than the concentration of the sintering aid in the joint interface.

4. A ceramic joint body according to any one of Claims 1-3, wherein at least one of the ceramic bodies contains the sintering aid and/or 50-5000 ppm of carbon.

5. A method of producing a ceramic joint body by joining two or more same or different ceramic bodies, which are applied a solution of a sintering aid having a concentration of 0.3 mol/l to 1 mol/l to a joint interface and firing at a temperature above 1840°C.

6. A method of producing a ceramic joint body by joining two or more same or different ceramic bodies, which include a sintering aid into one-side ceramic body to be joined and include no or relatively small sintering aid as compared a content of the sintering aid in the one-side ceramic body and then contacting and firing these ceramic bodies with each other.

7. A method of producing a ceramic joint body according to Claim 6, wherein the content of the sintering aid is not less than 0.5%.

8. A ceramic structural body for a semiconductor wafer comprising a ceramic substrate having an electric conductor in its inside and a ceramic body having an electric conductor for power supply electrically connecting to the electric conductor in the substrate and butt-joined to the ceramic substrate, **characterized in that** the ceramic body is joined to a portion of the ceramic substrate other than a region thereof treating a semiconductor wafer.

9. A ceramic structural body for a semiconductor wafer according to Claim 8, wherein the region treating the semiconductor wafer is a face of the ceramic substrate opposing to the semiconductor wafer.

10. A ceramic structural body for a semiconductor wafer according to Claim 8 or 9, wherein the ceramic substrate and the ceramic body comprise at least one of a nitride ceramic, an oxide ceramic and a carbide ceramic.

11. A ceramic structural body for a semiconductor wafer according to any one of Claims 8-10, wherein it is used within a temperature region of 100-700°C.

12. A ceramic structural body for a semiconductor wafer comprising a ceramic substrate having an electric conductor in its inside and a ceramic body having an electric conductor for power supply electrically connecting to the electric conductor in the substrate and butt-joined to the ceramic substrate, **characterized in that** ceramic particles grown are existed in joint interfaces of the ceramic bodies so as to infiltrate into the ceramic bodies located at both sides around the interface and a layer of sintering aid is eliminated from the joint interface.

13. A ceramic structural body for a semiconductor wafer according to Claim 12, wherein the sintering aid included in each ceramic body within a region ranging from the joint interface to 3 mm renders into a ratio Ch/Cl of the highest concentration Ch to the lowest concentration Cl within a range of 1-100.

14. A ceramic structural body for a semiconductor wafer according to Claim 12 or 13, wherein a concentration of the sintering aid in the ceramic body located one side around the joint interface is higher than a concentration of the sintering aid in the joint interface and a concentration of the sintering aid in the ceramic body located the other side around the joint interface is lower than the concentration of the sintering aid in the joint interface.

15. A ceramic structural body for a semiconductor wafer according to Claim 14, wherein the content of the sintering aid in the ceramic substrate is 0.5%-20% and the the content of the sintering aid in the ceramic body for the protection other than the neighborhood of the joint interface is 0%-10%.
